# FASCICULE DE BREVET EUROPEEN

(11) **EP 0 977 120 B1**
(45) Date de publication et mention de la délivrance du brevet: **23.04.2003**
(21) Numéro de dépôt: 99410094.9
(22) Date de dépôt: 30.07.1999
(51) Int. Cl.: G06F 11/10, G06F 11/00

(54) **Mémoire rom à correction par redondance**
Fehlerkorrektur in einem ROM mittels Redundanz
Error correction in a ROM by means of redundancy

(30) Priorité: 31.07.1998 FR 9810079
(43) Date de publication de la demande: 02.02.2000
(73) Titulaire: STMicroelectronics S.A., 92120 Montrouge (FR)
(72) Inventeur: Ferrant, Richard, 38330 Saint Ismier (FR)
(74) Mandataire: de Beaumont, Michel

(56) Documents cités:
- EP-A- 0 381 405
- US-A- 4 183 463
- US-A- 4 592 024

## Description

La présente invention concerne le domaine de la correction de circuits intégrés, et plus particulièrement la correction par redondance de circuits de mémoire morte ROM.

Une mémoire morte contient des informations binaires qui sont inscrites lors de sa fabrication, généralement par l'utilisation d'un masque de codage propre aux données contenues dans la mémoire.

Plusieurs types de défauts peuvent apparaître dans une mémoire morte lors de sa fabrication. Certains défauts peuvent rendre la mémoire complètement inopérante, par exemple un défaut de décodage d'adresse empêchant une lecture convenable des données mémorisées. D'autres défauts peuvent ne concerner qu'une partie de la mémoire, par exemple lorsqu'une seule cellule donne en lecture une valeur opposée à la valeur attendue. On s'intéresse par la suite à ce type de défauts en particulier.

Un moyen classique de tester la bonne fabrication d'une mémoire morte consiste à lire son contenu et à vérifier que toutes les informations mémorisées sont correctes. Cette opération de test est longue et coûteuse, et il est classique d'inclure un dispositif de test embarqué dans une mémoire morte. Un tel dispositif est conçu pour, lors d'une phase de test, recevoir successivement toutes les données mémorisées dans la mémoire, les additionner, les multiplier etc. suivant un algorithme de cryptage approprié et comparer le résultat final au résultat attendu des données de la mémoire. Lorsqu'il y a identité, la mémoire est considérée comme bonne.

Le brevet US-A-4592024 décrit une ROM comprenant un réseau de cellules mémoire dans lequel, lors d'une phase de test, l'ensemble des données stockées est lu, comparé par des moyens externes aux données attendues, et dans lequel, en cas de différence, les adresses des cellules défectueuses sont marquées.

Des mémoires mortes sont couramment intégrées dans des circuits numériques importants, pour mémoriser des informations telles que des polices de caractères dans un circuit de commande d'affichage, ou telles que des racines carrées dans un circuit de suivi de trajectoire ou telles que le microcode d'une application.

Si une mémoire morte d'un tel circuit est défectueuse, le circuit est inutilisable et doit être jeté.

Un objet de la présente invention est de prévoir un moyen relativement simple à mettre en oeuvre pour réparer un éventuel défaut de fabrication dans une mémoire morte.

Pour atteindre cet objet, la présente invention prévoit une mémoire morte comprenant une matrice dont chaque cellule est accessible au moyen d'une adresse de colonne et d'une adresse de rangée, comprenant une mémoire de parité pour mémoriser la parité attendue de chaque rangée et de chaque colonne, une mémoire d'adresses à programmation unique, programmable électriquement, propre à mémoriser seulement une adresse de rangée et une adresse de colonne, un circuit de test pour, lors d'une phase de test, calculer la parité de chaque rangée et de chaque colonne, comparer les parités calculées et attendues pour chaque rangée et chaque colonne, et en cas d'inégalité, marquer la rangée ou la colonne dans la mémoire d'adresses, et un circuit de correction pour, en mode normal, inverser la valeur lue dans une cellule de la matrice dont la rangée et la colonne sont marquées dans la mémoire d'adresses.

Selon un mode de réalisation de la présente invention, la mémoire d'adresses comprend une colonne de marquage et une rangée de marquage associées respectivement aux rangées et aux colonnes de la matrice, le circuit de test marquant une rangée en validant un drapeau dans la cellule de même rangée de la colonne de marquage, et marquant une colonne en validant un drapeau dans la cellule de même colonne de la rangée de marquage.

Selon un mode de réalisation de la présente invention, la mémoire d'adresses comprend une mémoire d'adresse de colonne dans laquelle le circuit de test marque une colonne en inscrivant son adresse de colonne et une mémoire d'adresse de rangée dans laquelle le circuit de test marque une rangée en inscrivant son adresse de rangée.

Selon un mode de réalisation de la présente invention, la matrice de la mémoire morte est divisée en plusieurs sous-matrices, chaque sous-matrice étant associée à une mémoire de parité et une mémoire d'adresses.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente de manière simplifiée une mémoire morte selon la présente invention et des circuits utilisés lors d'une phase de test ;
la figure 2 représente de manière simplifiée une mémoire morte selon la présente invention et des circuits utilisés en mode normal ;
la figure 3 représente de manière simplifiée une mémoire morte selon une variante de la présente invention et des circuits utilisés lors d'une phase de test ;
la figure 4 représente de manière simplifiée une mémoire morte selon une variante de la présente invention et des circuits utilisés en mode normal ; et
la figure 5 représente de manière simplifiée une mémoire morte selon une variante de la présente invention.

On propose selon la présente invention de mémoriser, lors de la fabrication d'une mémoire morte, une information supplémentaire égale à la parité attendue de chacune de ses colonnes et de chacune de ses rangées. On prévoit un circuit de test pour recalculer lors d'une phase de test la parité des colonnes et des rangées, pour les comparer aux parités attendues mémorisées. En cas d'inégalité, la colonne ou la rangée est marquée en inscrivant un drapeau dans une cellule électriquement programmable de même colonne ou de même rangée prévue à cet effet. On prévoit en outre un circuit de correction pour, en mode normal, inverser la donnée lue dans une cellule dont la rangée et la colonne ont été marquées.

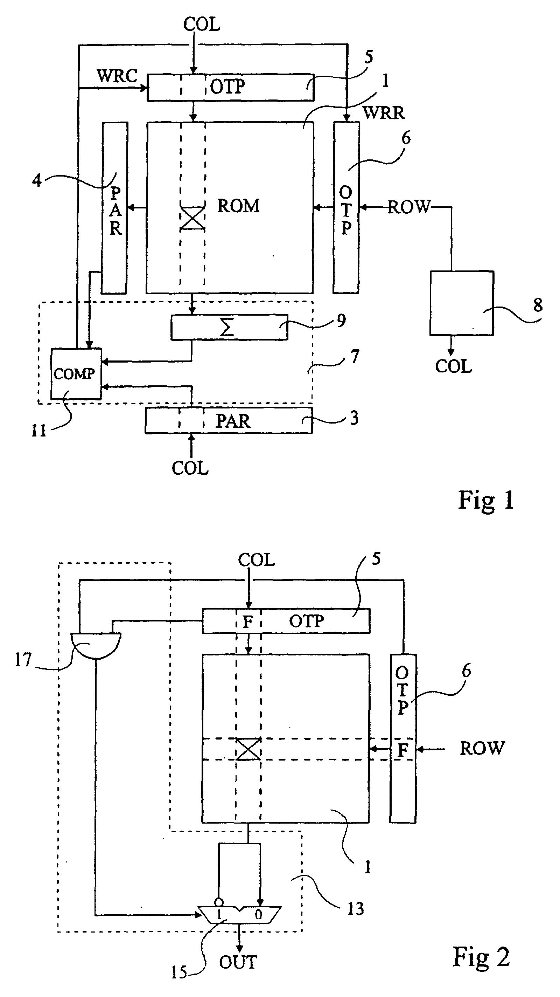

La figure 1 représente une matrice de mémoire morte 1 à laquelle sont associées une rangée et une colonne de parité 3 et 4 composées de cellules de mémoire morte et une rangée et une colonne de marquage 5 et 6 composées de cellules électriquement programmables. Ces cellules sont programmables de manière permanente, et peuvent par exemple être des fusibles, ou des cellules d'un type électriquement programmable accessible uniquement en lecture (EPROM).

Les rangées 3 et 5 ont des cellules associées respectivement aux colonnes de la matrice 1, et toutes deux reçoivent la même adresse de colonne COL que la matrice. Chaque cellule de la rangée 3 contient une information égale à la parité attendue de la colonne correspondante de la matrice 1.

Les colonnes 4 et 6 ont des cellules associées respectivement aux rangées de la matrice 1, et toutes deux reçoivent la même adresse de rangée ROW que la matrice. Chaque cellule de la colonne 4 contient une information égale à la parité attendue de la rangée correspondante de la matrice 1.

Un circuit de test 7 destiné à tester les colonnes puis les rangées de la matrice comprend un additionneur 9 qui reçoit les données fournies par la matrice, pour calculer la parité des colonnes et la parité des rangées de la matrice. Le circuit 7 comprend en outre un comparateur 11 des parités de colonne fournies par l'additionneur 9 et par la rangée 3, et des parités de rangée fournies par l'additionneur 9 et par la colonne 4. Le comparateur 11 est connecté pour produire une commande WRC d'écriture dans la rangée de marquage 5 lorsqu'il détecte une inégalité entre une parité de colonne calculée produite par l'additionneur 9 et une parité de colonne attendue lue dans la rangée 3. De même, le comparateur 11 est connecté pour produire une commande WRR d'écriture dans la colonne de marquage 6 lorsqu'il détecte une inégalité entre une parité de rangée calculée produite par l'additionneur 9 et une parité de rangée attendue lue dans la colonne 4.

Lors d'une première phase de test, un circuit de commande 8 fournit les adresses de colonne et de rangée pour lire successivement les cellules de toutes les rangées de chaque colonne de la matrice 1. L'additionneur 9 calcule ainsi la parité de chaque colonne. Le comparateur 11 compare alors, pour chaque colonne, la parité calculée à la parité attendue lue dans la cellule correspondante de la rangée de parité 3. Si la parité calculée et la parité attendue ne sont pas égales, la colonne contient une cellule défectueuse et le comparateur 11 active le signal WRC pour marquer la colonne en inscrivant un drapeau dans la cellule correspondante de la rangée de marquage 5.

De même, la colonne de parité 4 et la colonne de marquage 6 sont prévues pour, lors d'une deuxième phase de test menée rangée par rangée, localiser la rangée qui contient la cellule défectueuse et la marquer.

A l'issue de ces deux phases de test, le marquage de la colonne et de la rangée permet de repérer l'emplacement exact de la cellule défectueuse.

La figure 2 représente la matrice 1, la rangée 5 et la colonne 6 de marquage décrites précédemment, associées à des circuits utilisés dans le mode de fonctionnement normal de la mémoire. La borne de sortie de la matrice 1 est reliée à un circuit de correction 13. Le circuit de correction 13 comprend un multiplexeur 15 ayant une entrée normale et une entrée inverseuse, toutes deux connectées à la borne de sortie de la matrice 1. Les bornes de sortie de la rangée 5 et de la colonne 6 sont reliées à une borne de commande du multiplexeur 15 par l'intermédiaire d'une porte logique 17 prévue pour sélectionner l'entrée inverseuse du multiplexeur lorsque des drapeaux sont simultanément présents en sortie de la rangée 5 et de la colonne 6.

Quand on lit la matrice 1 à une adresse de colonne COL et à une adresse de rangée ROW, on lit également la rangée 5 à l'adresse de colonne COL et la colonne 6 à l'adresse de rangée ROW. Lorsqu'on lit la cellule défectueuse de la matrice 1, des drapeaux apparaissent aux deux entrées de la porte 17 et la donnée lue dans la cellule défectueuse est inversée. Lorsqu'on lit une autre cellule de la matrice 1, les entrées de la porte 17 ne sont pas activées simultanément, et le contenu de la matrice est lu tel quel.

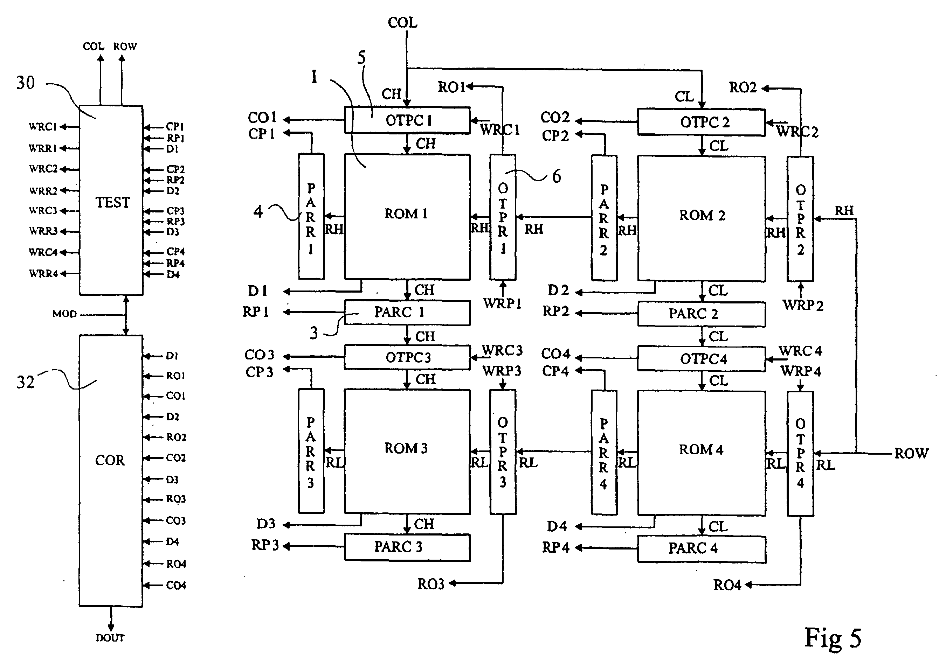

On remarque que si une deuxième cellule de la matrice 1 est défectueuse dans une colonne et dans une rangée différentes de celles de la première cellule défectueuse, le dispositif selon la présente invention ne permet pas d'effectuer une correction. En effet, le marquage de deux colonnes et de deux rangées différentes définit quatre emplacements défectueux au lieu de deux. Ainsi, on suppose que le procédé de fabrication de la matrice 1 est suffisamment fiable pour que seule une cellule de la matrice soit défectueuse à l'issue de la fabrication. Dans le cas contraire, on peut utiliser une variante telle que celle qui sera décrite en relation avec la figure 5.

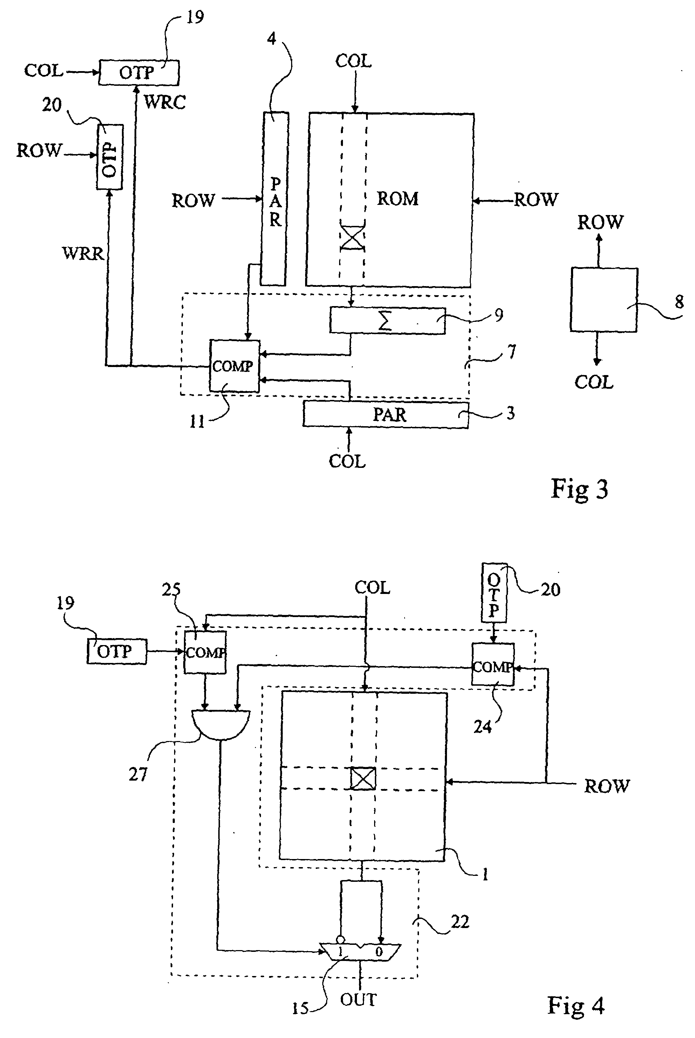

La figure 3 représente une variante de la présente invention. La matrice 1, les rangées 3 et 4 et le circuit de test 7 sont les mêmes qu'en figure 1. Un registre de colonne 19 électriquement programmable est connecté pour mémoriser l'adresse COL lorsqu'il reçoit un signal WRC. Un registre de rangée 20 électriquement programmable est connecté pour mémoriser l'adresse ROW lorsqu'il reçoit un signal WRR.

Lors d'une première phase de test, semblable à la phase de test menée colonne par colonne décrite en relation avec la figure 1, on recherche une colonne dont la parité calculée ne correspond pas à la parité attendue. Si une telle colonne est trouvée, son adresse de colonne COL est inscrite dans le registre 19.

De même, lors d'une deuxième phase de test, semblable à la phase de test menée rangée par rangée décrite en relation avec la figure 1, on recherche une rangée dont la parité calculée ne correspond pas à la parité attendue. Si une telle rangée est trouvée, son adresse de rangée ROW est inscrite dans le registre 20.

La figure 4 représente la matrice 1, le registre de colonne 19 et le registre de rangée 20 décrits précédemment, lors de leur utilisation en mode normal. Un circuit de correction 22 comprend le même multiplexeur 15 que le circuit de correction 13 de la figure 2. Il comprend en outre deux comparateurs 24 et 25 dont les bornes de sortie sont connectées à une borne de commande du multiplexeur 15 par l'intermédiaire d'une porte logique 27 prévue pour sélectionner l'entrée inverseuse du multiplexeur 15 lorsque les sorties des comparateurs 24 et 25 sont simultanément actives. Le comparateur 25 est connecté pour comparer l'adresse COL à l'adresse mémorisée dans le registre de colonne 19. De même, le comparateur 24 est connecté pour comparer l'adresse ROW à l'adresse mémorisée dans le registre de rangée 20.

Lorsqu'on lit la cellule défectueuse de la matrice 1, l'adresse COL est égale à l'adresse mémorisée dans le registre 19, et la sortie du comparateur 25 est activée. De même, l'adresse ROW est alors égale à l'adresse mémorisée dans le registre 20, et la sortie du comparateur 24 est activée. Les entrées de la porte 27 sont activées et la donnée lue dans la cellule défectueuse est inversée. Lorsqu'on lit les autres cellules de la matrice, les sorties des comparateurs 24 et 25 ne sont jamais simultanément activées, et la donnée lue dans la cellule n'est pas inversée.

La figure 5 représente une variante de la présente invention permettant de corriger quatre erreurs dans une même matrice. Pour cela, la matrice est divisée en quatre sous-matrices ROM1, ROM2, ROM3, ROM4 et chaque sous-matrice est traitée comme la matrice 1 de la figure 1. Ainsi, chaque sous-matrice est associée à une rangée de marquage 5 (OTPC1, OTPC2, OTPC3, OTPC4), une colonne de marquage 6 (OTPR1, OTPR2, OTPR3, OTPR4), une rangée de parité 3 (PARC1, PARC2, PARC3, PARC4) et une colonne de parité 4 (PARR1, PARR2, PARR3, PARR4).

Les adresses de colonne et de rangée sont réparties de manière que les sous-matrices ROM1 et ROM3 ainsi que les rangées de marquage et de parité qui leur sont associées reçoivent la moitié supérieure des adresses de colonne et que les sous-matrices ROM2 et ROM4 ainsi que les rangées de marquage et de parité qui leur sont associées reçoivent la moitié inférieure des adresses de colonne. De même, les sous-matrices ROM1 et ROM2 ainsi que les colonnes de marquage et de parité qui leur sont associées reçoivent la moitié supérieure des adresses de rangée et les sous-matrices ROM3 et ROM4 ainsi que les colonnes de marquage et de parité qui leur sont associées reçoivent la moitié inférieure des adresses de rangée.

Un circuit de test 30 remplit pour chaque sous-matrice les fonctions du circuit de test 7 et du circuit de commande 8 de la figure 1. Il reçoit la sortie D de la sous-matrice, et les sorties CP et RP de la colonne et de la rangée de parité qui lui sont associées. Il produit lors d'une phase de test les signaux WRC et WRR d'écriture dans la rangée de marquage OTPC et dans la colonne de marquage OTPR associées à la sous matrice.

Un circuit de commande 32 remplit pour chaque sous-matrice les fonctions du circuit de commande 13 de la figure 2. Il reçoit la sortie D de la sous-matrice, et les sorties RO et CO de la colonne et de la rangée de marquage qui lui sont associées. Il produit un signal de sortie DOUT égal au signal D inversé si les signaux RO et CO sont actifs simultanément et égal au signal D dans le cas contraire.

Une commande de sélection de mode MOD permet d'activer le bloc 30 en mode de test et le bloc 32 en mode normal.

Ce mode de réalisation permet de corriger quatre erreurs dans la matrice, c'est à dire une erreur par sous matrice. L'homme du métier adaptera sans difficultés la présente invention à une correction d'un plus grand nombre d'erreurs.

On remarquera que le mode de réalisation de la figure 5 utilise les circuits de test des figures 1 et 2, mais qu'on peut avantageusement utiliser les circuits de test des figures 3 et 4 dans le mode de réalisation de la figure 5.

On peut également utiliser pour le test des colonnes et des rangées de la matrice une signature différente de la parité. La signature attendue de chaque colonne et de chaque rangée sera alors mémorisée dans une rangée et une colonne semblables à celles décrites précédemment, et les circuits de test seront prévus pour recalculer la signature lors des phases de test.

## Revendications

1. Mémoire morte comprenant une matrice (1) dont chaque cellule est accessible au moyen d'une adresse de colonne (COL) et d'une adresse de rangée (ROW), **caractérisée en ce qu'**elle comprend
une mémoire de parité (3, 4) pour mémoriser la parité attendue de chaque rangée et de chaque colonne,
une mémoire d'adresses à programmation unique, programmable électriquement (5, 6 ; 19, 20), propre à mémoriser seulement une adresse de rangée et une adresse de colonne,
un circuit de test (7, 8) pour, lors d'une phase de test, calculer la parité de chaque rangée et de chaque colonne, comparer les parités calculées et attendues pour chaque rangée et chaque colonne, et en cas d'inégalité, marquer la rangée ou la colonne dans la mémoire d'adresses, et
un circuit de correction (13 ; 22) pour, en mode normal, inverser la valeur lue dans une cellule de la matrice dont la rangée et la colonne sont marquées dans la mémoire d'adresses.

2. Mémoire morte selon la revendication 1, **caractérisée en ce que** la mémoire d'adresses comprend une colonne de marquage (6) et une rangée de marquage (5) associées respectivement aux rangées et aux colonnes de la matrice, le circuit de test marquant une rangée en validant un drapeau dans la cellule de même rangée de la colonne de marquage, et marquant une colonne en validant un drapeau dans la cellule de même colonne de la rangée de marquage.

3. Mémoire morte selon la revendication 1, **caractérisée en ce que** la mémoire d'adresses comprend une mémoire d'adresse de colonne (19) dans laquelle le circuit de test marque une colonne en inscrivant son adresse de colonne et une mémoire d'adresse de rangée (20) dans laquelle le circuit de test marque une rangée en inscrivant son adresse de rangée.

4. Mémoire morte selon la revendication 1, **caractérisée en ce que** sa matrice est divisée en plusieurs sous-matrices, chaque sous-matrice étant associée à une mémoire de parité et une mémoire d'adresses.

## Claims

1. A ROM including an array (1), each cell of which is accessible by means of a column address (COL) and of a row address (ROW), **characterized in that** it includes:
a parity memory (3, 4) for storing the expected parity of each row and of each column,
an electrically programmable one-time programmable address memory (5, 6; 19, 20), capable of storing only one row address and one column address,
a testing circuit (7, 8) for, during a test phase, calculating the parity of each row and of each column, comparing the calculated and expected parities for each row and each column, and in case they are not equal, marking the row or column in the address memory, and
a correction circuit (13; 22) for, in normal mode, inverting the value read from the array cell having its row and column marked in the address memory.

2. The ROM of claim 1, **characterized in that** the address memory includes a marking column (6) and a marking row (5) respectively associated with the array rows and columns, the testing circuit marking a row by enabling a flag in the cell of same row of the marking column, and marking a column by enabling a flag in the cell of same column of the marking row.

3. The ROM of claim 1, **characterized in that** the address memory includes a column address memory (19) in which the testing circuit marks a column by writing its column address and a row address memory (20) in which the circuit marks a row by writing its row address.

4. The ROM of claim 1, **characterized in that** its array is divided into several sub-arrays, each sub-array being associated with a parity memory and an address memory.

## Patentansprüche

1. Festspeicher mit einer Matrix (1), bei der auf jede Zelle Zugriff besteht mit Hilfe einer Spaltenadresse (COL) und einer Zeilenadresse (ROW), **dadurch gekennzeichnet, dass** er aufweist
- einen Paritätsspeicher (3, 4), um die erwartete Parität jeder Zeile und jeder Spalte zu speichern,
- einen elektrisch programmierbaren Adressenspeicher (5, 6; 19, 20) mit Einmal-Programmierung, der zum Speichern lediglich einer Zeilenadresse und einer Spaltenadresse ausgelegt ist,
- eine Testschaltung (7, 8), um, während einer Testphase, die Parität jeder Zeile und jeder Spalte zu berechnen, die berechneten und die erwarteten Paritäten für jede Zeile und jede Spalte zu vergleichen und im Falle der Ungleichheit die Zeile oder die Spalte in dem Adressenspeicher zu markieren, und
- eine Korrekturschaltung (13; 22), um, im normalen Modus, den in einer Zelle der Matrix, deren Zeile und Spalte in dem Adressenspeicher markiert sind, ausgelesenen Wert zu invertieren.

2. Festspeicher nach Anspruch 1, **dadurch gekennzeichnet, dass** der Adressenspeicher eine Markierungsspalte (6) und eine Markierungszeile (5) aufweist, die Zeilen bzw. Spalten der Matrix zugeordnet sind, wobei die Testschaltung eine Zeile markiert, indem in der Zelle mit der gleichen Zeile wie in der Markierungsspalte ein Flag gesetzt wird, und eine Spalte markiert, indem ein Flag in der Zelle mit der gleichen Spalte wie in der Markierungszeile gesetzt wird.

3. Festspeicher nach Anspruch 1, **dadurch gekennzeichnet, dass** der Adressenspeicher einen Spaltenadressenspeicher (19), indem die Testschaltung eine Spalte markiert, in dem sie ihre Spaltenadresse einschreibt, und einen Zeilenadressenspeicher (20) aufweist, indem die Testspaltung eine Zeile markiert, indem sie ihre Zeilenadresse einschreibt.

4. Festspeicher nach Anspruch 1, **dadurch gekennzeichnet, dass** seine Matrix in mehrere Untermatrizen aufgeteilt ist, wobei jede Untermatrix einem Paritätsspeicher und einem Adressenspeicher zugeordnet ist.
